# EUROPEAN PATENT APPLICATION

(11) **EP 1 174 915 A2**
(43) Date of publication of application: **23.01.2002**
(21) Application number: 01116694.9
(22) Date of filing: 17.07.2001
(51) Int. Cl.: H01L 21/316

(54) **Deposition of a silicon containing insulating thin film**

(30) Priority: 21.07.2000 JP 2000221379; 18.09.2000 JP 2000281263
(71) Applicant: Canon Sales Co., Inc., Minato-ku, Tokyo 108-0073 (JP); Semiconductor Process Laboratory Co., Ltd., Minato-ku, Tokyo 108-0075 (JP)
(72) Inventor: Oku, Taizo, Canon Sales Co., Inc., Tokyo 108-0073 (JP); Aoki, Junichi, Canon Sales Co., Inc., Tokyo 108-0073 (JP); Yamamoto, Youichi, Canon Sales Co., Inc., Tokyo 108-0073 (JP); Koromokawa, Takashi, Canon Sales Co., Inc., Tokyo 108-0073 (JP); Maeda, Kazuo, Semiconductor Process Laboratory Co., Tokyo 108-0075 (JP)
(74) Representative: Marx, Lothar, Dr.

(57) **Abstract**

The present invention relates to a film forming method of forming an interlayer insulating film having a low dielectric constant to cover a wiring. In construction, an insulating film for covering a wiring is formed on the substrate by plasmanizing a film forming gas, that consists of any one selected from a group consisting of alkoxy compound having Si-H bonds and siloxane having Si-H bonds and any one oxygen-containing gas selected from a group consisting of O₂, N₂O, NO₂, CO, CO₂, and H₂O, to react.

## Description

### BACKGROUND OF THE INVENTION

### 1. Field of the Invention

The present invention relates to a film forming method, a semiconductor device and a semiconductor device manufacturing method and, more particularly, a film forming method, a semiconductor device and a semiconductor device manufacturing method for forming an interlayer insulating film having a low dielectric constant to cover a wiring.

### 2. Description of the Prior Art

In recent years, the miniaturization and the reduction in thickness of the pattern are required with the higher integration degree and the higher density of the semiconductor integrated circuit devices. In addition, since the higher speed of the data transfer rate is also required.

Therefore, the insulating film having the low dielectric constant (referred to as a "low dielectric constant insulating film" hereinafter) and the small RC delay is employed. As such insulating film, there are the SiOF film having the relative dielectric constant 3.5 to 3.8, the porous SiO₂ film having the relative dielectric constant 3.0 to 3.1, etc., for example.

However, essentially the low dielectric constant insulating film is ready to contain the moisture and is ready to pass the incoming moisture. Therefore, if such low dielectric constant insulating film is employed alone as the interlayer insulating film, the corrosion of the wiring and the increase in the leakage current are easily caused. In order to prevent to them, the barrier insulating film containing Si and N or Si and C is often interposed between the wiring and the low dielectric constant insulating film.

More particularly, in the semiconductor device having the multi-layered wiring, the interlayer insulating film containing barrier layers is formed between the upper wiring and the lower wiring. The interlayer insulating film containing barrier layers is formed by laminating the barrier insulating film containing Si and N or Si and C, the low dielectric constant insulating film, and the barrier insulating film containing Si and N or Si and C in sequence.

However, the insulating film containing Si and N has the high relative dielectric constant. Therefore, even if such insulating film of the thinner film thickness is employed as the barrier insulating film, the dielectric constant of the overall interlayer insulating film is increased.

Also, the relative dielectric constant of the barrier insulating film containing Si and C is relatively low such as about 5 rather than the barrier insulating film containing Si and N. But such barrier insulating film containing Si and C cannot sufficiently suppress the increase in the leakage current.

### SUMMARY OF THE INVENTION

It is an object of the present invention to provide a film forming method, a semiconductor device and a semiconductor device manufacturing method, that are capable of lowering a dielectric constant of an interlayer insulating film as a whole and suppressing a change of the dielectric constant due to moisture absorption, while preventing corrosion of a wiring and an increase in a leakage current.

In the film forming method according to the present invention, the silicon-containing insulating film is formed by plasmanizing a film forming gas consisting of any one selected from a group consisting of alkoxy compound having Si-H bonds and siloxane having Si-H bonds and any one oxygen-containing gas selected from a group consisting of O₂, N₂O, NO₂, CO, CO₂, and H₂O, to react. According to the experiment, it is found that such silicon-containing insulating film is dense, has the high moisture proof, has the small amount of contained moisture in the film, and the small relative dielectric constant.

Therefore, if the above silicon containing insulating film is employed as the barrier insulating films (a lower protection layer and an upper protection layer) that constitute the interlayer insulating film interposed between the upper wiring and the lower wiring, and sandwich the low dielectric constant insulating film, the dielectric constant of the overall interlayer insulating film can be lowered while preventing the corrosion of the wiring and the increase in the leakage current.

According to the semiconductor device of the present invention, the silicon-containing insulating film whose peak of the absorption intensity of the infrared rays is in a range of the wave number 2270 to 2350 cm⁻¹, whose film density is in a range of 2.25 to 2.40 g/cm³, and whose relative dielectric constant is in a range of 3.3 to 4.3 is formed on the substrate.

According to the experiment of the inventors of this application, it is found that the silicon-containing insulating film having such characteristics has the high mechanical strength, is dense, is excellent in the water resistance, and has the small amount of contained moisture in the film like the silicon nitride film, and has the relative dielectric constant smaller than the silicon nitride film.

According to the configuration obtained by applying the silicon-containing insulating film of the present invention to the semiconductor device, the above silicon- containing insulating film is formed to cover the wiring and contact to it, otherwise the above silicon-containing insulating film is formed as the protection layer on the insulating film that covers the wiring.

The silicon-containing insulating film of the present invention has the low dielectric constant, has the small amount of contained moisture in the film, is dense, and is excellent in the water resistance. Therefore, if the silicon-containing insulating film is employed as the protection layer for covering the wirings, etc., the corrosion of the wiring can be prevented by preventing the incoming moisture from entering the semiconductor device while reducing the parasitic capacitance between the wirings.

Also, the upper and lower wirings and the interlayer insulating film interposed between the upper and lower wirings are provided on the substrate, and the interlayer insulating film is formed of the silicon-containing insulating film according to the present invention.

Also, the interlayer insulating film is constructed in order from the bottom by the lower protection layer formed of the silicon-containing insulating film according to the present invention, the main insulating film, and the upper protection layer formed of the silicon-containing insulating film according to the present invention.

If the main insulating film is formed of the SiOF film, the silicon-containing insulating film according to the present invention can prevent the fluorine (F) element from diffusing to the outer peripheral portions of the silicon-containing insulating film. Also, if the main insulating film is formed of the porous insulating film having the high hygroscopicity, the silicon-containing insulating film according to the present invention can prevent the incoming of the moisture into the porous insulating film and thus the increase of the dielectric constant due to the moisture absorption can be prevented.

Also, since the silicon nitride film is not employed as the upper and lower protection layers of the main insulating film but the silicon-containing insulating film having the low relative dielectric constant is employed, the dielectric constant of the overall interlayer insulating film can be reduced.

### BRIEF DESCRIPTION OF THE DRAWINGS

FIG.1 is a side view showing a configuration of the plasma CVD film forming equipment employed in a film forming method according to a first embodiment of the present invention;
FIG.2A to FIG.2E are sectional views showing structures of samples employed to examine characteristics of a silicon-containing insulating film that is formed by the film forming method according to the first embodiment of the present invention, and structures of comparative samples;
FIG.3A and FIG.3B are tables showing examined results of a film density of the insulating film that is formed by the film forming method according to the second embodiment of the present invention using the sample of FIG.2A;
FIG.4 is a graph showing examined results of a moisture content and a water resistance of the silicon-containing insulating film that is formed by the film forming method according to a second embodiment of the present invention using the sample of FIG.2A;
FIG.5A is a graph showing examined results of an infrared absorption intensity of the silicon-containing insulating film that is formed by the film forming method according to a second embodiment of the present invention using the sample of FIG.2A;
FIG.5B is a graph showing examined results of an infrared absorption intensity of the silicon-containing insulating film that is formed by the film forming method according to a second embodiment of the present invention using the comparative sample of FIG.2A;
FIG. 6 is a graph showing examined results of a water resistance of the silicon-containing insulating film that is formed by the film forming method according to a second embodiment of the present invention using the sample of FIG.2B;
FIG.7 is a graph showing examined results of a water resistance due to a pressure-cooker test of the silicon-containing insulating film that is formed by the film forming method according to a second embodiment of the present invention using the sample of FIG.2B;

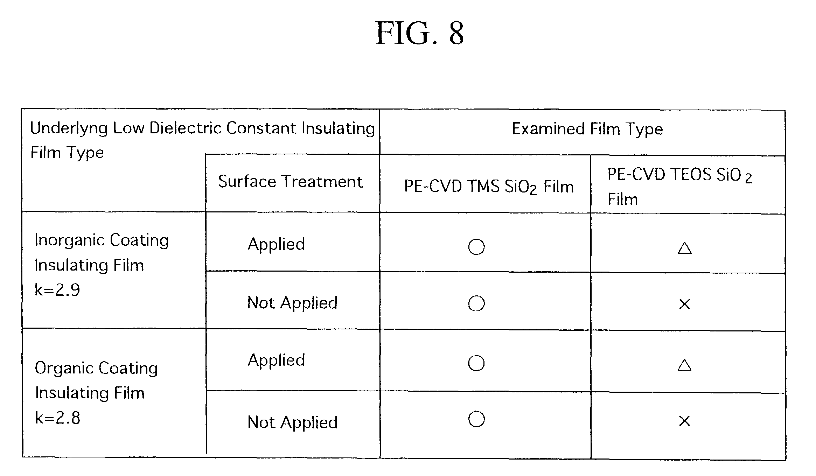

FIG.8 is a table showing examined results of an adhesiveness of the silicon-containing insulating film, that is formed by the film forming method according to the second embodiment of the present invention, to a coated insulating film using the sample of FIG.2C;
FIG. 9 is a graph showing examined results of a defect generating rate due to a heat cycle using the sample of FIG.2D according to the second embodiment of the present invention;
FIG.10 is a graph showing examined results of a barrier characteristic to a copper of the silicon-containing insulating film that is formed by the film forming method according to the second embodiment of the present invention;
FIGS.11A and 11B are sectional views showing a semiconductor device manufacturing method according to a third embodiment of the present invention;
FIGS.12A to 12C are sectional views showing a semiconductor device manufacturing method according to a fourth embodiment of the present invention;
FIGS.13A to 13F are sectional views showing a semiconductor device manufacturing method according to a fifth embodiment of the present invention;
FIGS.14A to 14C are sectional views showing a semiconductor device manufacturing method according to a sixth embodiment of the present invention; and
FIG.15 is a sectional view showing a semiconductor device manufacturing method according to other embodiment of the present invention.
Fig. 16 is a sectional view showing a semiconductor device manufacturing method according to other embodiments of the present invention.

### DESCRIPTION OF THE PREFRRED EMBODIMENTS

Embodiments of the present invention will be explained with reference to the accompanying drawings hereinafter.

### (First Embodiment)

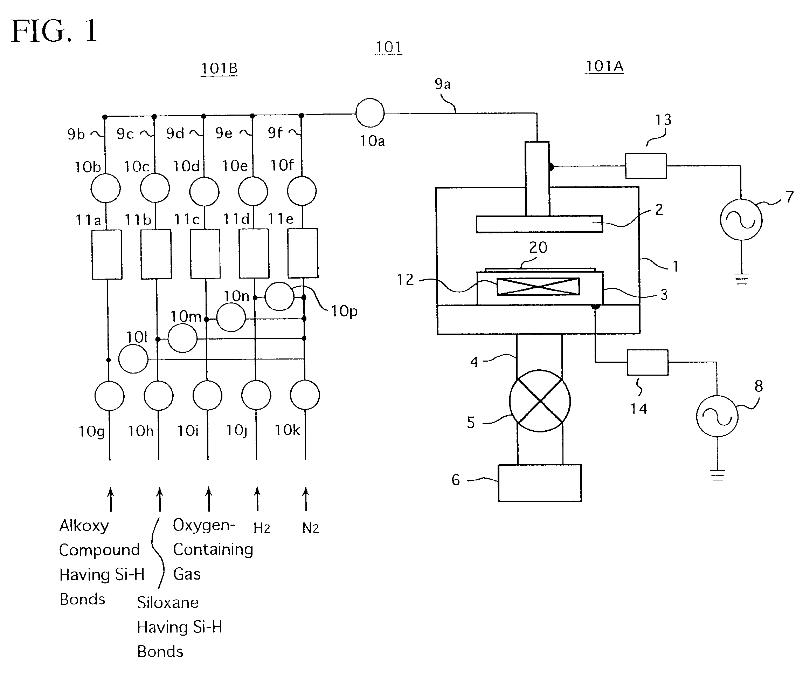

FIG.1 is a side view showing a configuration of the parallel-plate type plasma CVD film forming equipment 101 employed in a film forming method according to an embodiment of the present invention.

This plasma CVD film forming equipment 101 comprises a film forming portion 101A that is the place at which a silicon-containing insulating film is formed by the plasma gas on a substrate 20, and a film forming gas supplying portion 101B having a plurality of gas supply sources constituting the film forming gas.

As shown in FIG.1, the film forming portion 101A has a chamber 1 whose pressure can be reduced, and the chamber 1 is connected to an exhausting device 6 via an exhaust pipe 4. A switching valve 5 for controlling the open and the close between the chamber 1 and the exhausting device 6 is provided in the middle of the exhaust pipe 4. A pressure measuring means such as a vacuum gauge (not shown) for monitoring the pressure in the chamber 1 is provided to the chamber 1.

A pair of opposing upper electrode (first electrode) 2 and lower electrode (second electrode) 3 are provided to the chamber 1. A high frequency power supply (RF power supply) 7 for supplying a high frequency power having a frequency of 13.56 MHz is connected to the upper electrode 2, while a low frequency power supply 8 for supplying a low frequency power having a frequency of 380 kHz is connected to the lower electrode 3. The film forming gas is plasmanized by supplying the power to the upper electrode 2 and the lower electrode 3 from these power supplies 7, 8. The upper electrode 2, the lower electrode 3, and the power supplies 7, 8 constitute the plasma generating means for plasmanizing the film forming gas.

As the plasma generating means, there are the means for generating the plasma by the first and second electrodes 2, 3 of the parallel-plate type, the means for generating the plasma by ECR (Electron Cyclotron Resonance) method, the means for generating the helicon plasma by irradiating the high frequency power from the antenna, etc., for example.

The upper electrode 2 is also used as a film forming gas distributor. A plurality of through holes are formed in the upper electrode 2, and opening portions of the through holes in the surface opposing to the lower electrode 3 serve as discharge ports (inlet ports) of the film forming gas. The discharge ports of the film forming gas, etc. are connected to the film forming gas supplying portion 101B via a pipe 9a. Also, a heater (not shown) may be provided to the upper electrode 2, as the case may be. This is because, if the upper electrode 2 is heated at the temperature of almost 100 °C during the film formation, particles made of reaction products of the film forming gas, etc. can be prevented from sticking onto the upper electrode 2.

The lower electrode 3 is also used as a loading table for the substrate 20. A heater 12 for heating the substrate 20 on the loading table is provided to the lower electrode 3.

In the film forming gas supplying portion 101B, a supply source for the alkoxy compound having Si-H bonds; a supply source for the siloxane having Si-H bonds; a supply source for any one oxygen-containing gas selected from a group consisting of oxygen (O₂), nitrogen monoxide (N₂O), nitrogen dioxide (NO₂), carbon monoxide (CO), carbon dioxide (CO₂), and water (H₂O); a supply source for the hydrogen (H₂); and a supply source for the nitrogen (N₂) are provided.

As for the alkoxy compound having Si-H bonds or the siloxane having Si-H bonds as the film forming gas to which the present invention is applied, followings may be employed as the typical examples.
(i) alkoxy compound having Si-H bonds
   trimethoxysilane (TMS: SiH(OCH₃)₃)
(ii) siloxane having Si-H bonds
   tetramethyldisiloxane (TMDSO:

   (CH₃)₂HSi-O-SiH(CH₃)₂)

These gases are supplied appropriately to the chamber 1 of the film forming portion 101A via branch pipes 9b to 9f and a pipe 9a to which all branch pipes 9b to 9f are connected. Flow rate controlling means 11a to 11e and switching means 10b to 10k for controlling the open and the close of the branch pipes 9b to 9f are provided in the middle of the branch pipes 9b to 9f. A switching means 10a for controlling the open and the close of the pipe 9a is provided in the middle of the pipe 9a. Also, in order to purge the residual gas in the branch pipes 9b to 9e by flowing the N₂ gas, switching means 101 to 10n, 10p for controlling the open and the close between the branch pipe 9f, that is connected to the N₂ gas supply source, and remaining branch pipes 9b to 9e are provided. The N₂ gas purges the residual gas in the pipe 9a and the chamber 1 in addition to the branch pipes 9b to 9e.

According to the film forming equipment 101 described above, the supply source for supplying at least any one of the alkoxy compound having Si-H bonds and the siloxane having Si-H bonds and the oxygen-containing gas supply source are provided, and also the plasma generating means 2, 3, 7, 8 for plasmanizing the film forming gas are provided.

The insulating film containing Si, O, C, H can be formed by the plasma CVD method by using the above plasma CVD equipment. Therefore, as shown in a second embodiment described in the following, it is possible to form the insulating film that has the low dielectric constant, has the small amount of moisture content, is dense and is excellent in water resistance. Also, this insulating film has the good adhesiveness to the organic coating insulating film or the inorganic coating insulating film, and has the higher capability for preventing the diffusion of copper (Cu).

In particular, the power supplies 7, 8 for supplying the powers having two high and low frequencies to the first and second electrodes 2, 3 of parallel-plate type respectively are connected to them. Therefore, the plasma can be generated by applying the powers having these two high and low frequencies to the electrodes 2, 3 respectively. Thus, the insulating film formed in this manner is dense.

### (Second Embodiment)

The examination, made by the inventors of the present invention, about the silicon-containing insulating film, that is formed by the above plasma CVD equipment, will be explained hereunder.

First, the well-known parallel-plate type plasma CVD equipment is employed as the above plasma CVD equipment. The lower electrode 3 of the upper and lower electrodes 2, 3 is also used as a substrate holder, and the heater 12 for heating the substrate is built in the lower electrode 3.

### (Formation of Samples)

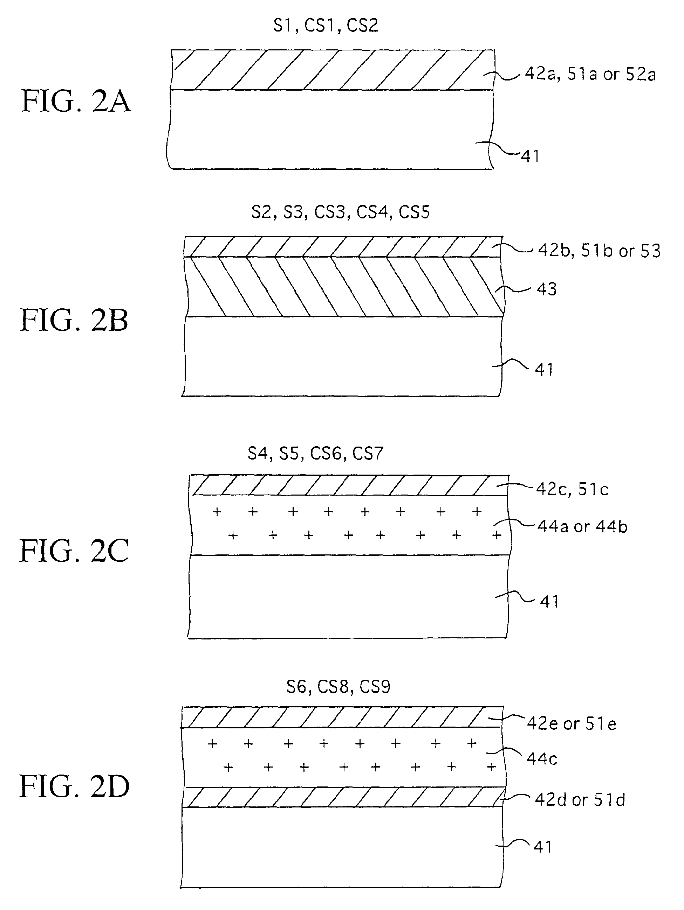

FIGS.2A to 2E are sectional views showing samples having the silicon oxide film (a silicon-containing insulating film) of the present invention.

As shown in FIG.2A, a sample S1 has a silicon oxide film (this means a silicon-containing insulating film, and referred to as a "PE-CVD TMS SiO₂ film" hereinafter) 42a, that is formed by the PE-CVD method using the film forming gas containing trimethoxysilane (TMS) on a silicon substrate 41. For the sake of comparison, a comparative sample CS1 having a silicon oxide film (referred to as a "PE-CVD TEOS SiO₂ film" hereinafter) 51a, that is formed by the PE-CVD method using the film forming gas containing tetraethoxysilane (TEOS) on the silicon substrate 41, and a comparative sample CS2 having a silicon oxide film (referred to as a "PE-CVD SiH₄ SiO₂ film" hereinafter) 52a, that is formed by the PE-CVD method using the film forming gas containing monosilane (SiH₄) on the silicon substrate 41, are prepared.

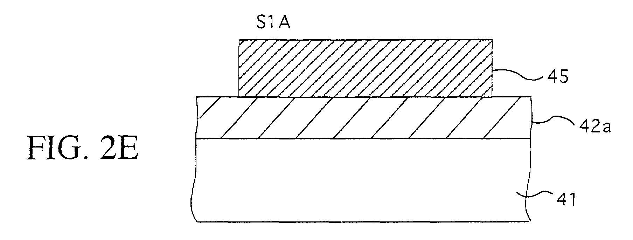

As shown in FIG.2E, a sample S1A is formed by further forming an electrode 45 on the PE-CVD TMS SiO₂ film 42a, in the sample S1 in which the PE-CVD TMS SiO₂ film 42a is formed on the silicon substrate 41. The mercury probe is employed as the electrode 45, and a contact area between the mercury probe and the PE-CVD TMS SiO₂ film 42a is 0.0230 cm².

As shown in FIG.2B, samples S2, S3 are formed by forming a BPSG film 43 having an amount of contained phosphorus of 7 mol% and a film thickness of about 500 nm and a PE-CVD TMS SiO₂ film 42b to be tested in sequence on the silicon substrate (Si substrate) 41. A film thickness of the PE-CVD TMS SiO₂ film 42b is set to 100 nm in the sample S2, and a film thickness of the PE-CVD TMS SiO₂ film 42b is set to 200 nm in the sample S3. For comparison, a comparative sample CS3 employing a PE-CVD TEOS SiO₂ film 51b having a film thickness of 200 nm in place of the PE-CVD TMS SiO₂ film 42b, a comparative sample CS4 employing a PE-CVD SiH₄ SiO₂ film 52b having a film thickness of 200 nm similarly, and a comparative sample CS5 employing a silicon nitride film (referred to as a "PE-CVD SiN film" hereinafter) 53, that is formed by the plasma CVD method using the film forming gas containing SiH₄, NH₃ and N₂ similarly to have a film thickness of 200 nm, are prepared.

As shown in FIG.2C, samples S4, S5 are formed by forming low dielectric constant insulating films 44a, 44b and a PE-CVD TMS SiO₂ film 42c in sequence on the silicon substrate (Si substrate) 41. An inorganic coating insulating film 44a is employed as the low dielectric constant insulating film in the sample S4, and an organic coating insulating film 44b is employed similarly in the sample S5. For comparison, comparative samples CS6, CS7 employing a PE-CVD TEOS SiO₂ film 51c in place of the PE-CVD TMS SiO₂ film 42c are formed. The inorganic coating insulating film 44a is employed as the low dielectric constant insulating film in the comparative sample CS6, and the organic coating insulating film 44b is employed similarly in the comparative sample CS7.

The inorganic coating insulating film is such an insulating film that is formed by coating the coating liquid such as HSQ (product name: manufactured by Dow Corning Co., Ltd.), MSQ (product name), R7 (product name: Hitachi Chemical Co., Ltd.), etc. The compound having one carbon or less is distinctively contained as the component compound in the coating liquid. The organic coating insulating film is formed by coating the coating liquid such as FLARE (product name: manufactured by Allied Signal Co., Ltd.), SiLK (product name: manufactured by The Dow Chemical Co.), etc. The compound having two carbons or more is distinctively contained as the component compound in the coating liquid.

As shown in FIG.2D, a sample S6 is formed by forming a PE-CVD TMS SiO₂ film (lower protection layer) 42d having a film thickness of about 150 nm, a coating insulating film (main insulating film) 44c having a film thickness of about 200 nm, and a PE-CVD TMS SiO₂ film (upper protection layer) 42e having a film thickness of about 200 nm in sequence on the silicon substrate 41. The coating insulating film 44c is formed by spin-coating the coating liquid (FOx (product name)), that is produced by dissolving HSQ (Hydrogen silsesquioxane) into the solvent, then baking the coated liquid at the temperature of 150, 200, and 350 °C for one minute in the nitrogen respectively, and then curing the resultant at the temperature of 400 °C for 50 minutes in the nitrogen. For comparison, a comparative sample CS8 in which a PE-CVD TEOS SiO₂ film 51d is formed in place of the PE-CVD TMS SiO₂ film 42d as the lower protection layer and a comparative sample CS9 in which PE-CVD TEOS SiO₂ films 51d, 51e are formed in place of the PE-CVD TMS SiO₂ films 42d, 42e as the upper and lower protection layers are prepared.

The PE-CVD TMS SiO₂ films 42a to 42e of the samples S1 to S6 are formed by using the above plasma CVD equipment under following film forming conditions.

Film forming gas: TMS+N₂O
TMS gas flow rate: 100 sccm
N₂O gas flow rate: 3000 sccm
Gas pressure: 0.7 Torr

### Plasmanizing conditions

Power density applied to the upper electrode 2: 0.3 W/cm²
   (frequency 13.56 MHz)
Power density applied to the lower electrode 3: 0.3 W/cm²
   (frequency 380 kHz)

In this film-forming apparatus, these power densities correspond to the applied powers 750W to the electrodes, respectively.
Substrate temperature: 300 to 400 °C
Film forming thickness: t nm

The above plasma CVD apparatus 101 is also employed for forming the PE-CVD TEOS SiO₂ film 51a of the comparative sample CS1, the PE-CVD SiH₄ SiO₂ film 52a of the comparative sample CS2, the PE-CVD TEOS SiO₂ films 51b to 51e of the comparative samples CS3, CS4, CS6 to CS9, the PE-CVD SiN film 53 of the comparative sample CS5.

Following characteristics of the PE-CVD TMS SiO₂ film 42a to 42e formed as above are examined.

### (i) Basic characteristic

The film forming rate of the above film forming conditions is at the range of about 160 to 170 nm/min.

Also, the refractive index of the formed PE-CVD TMS SiO₂ film is at the range of 1.477 to 1.48, and the film stress is -250 Mpa or 3.0 × 10⁹ dyne/cm². The ellipsometer using the He-Ne laser having a wavelength of 6338 angstrom is employed to measure the refractive index. Also, the optilever laser scanning system is employed to measure the film stress.

Also, the film thickness (t) is 500 nm, and the relative dielectric constant of the PE-CVD TMS SiO₂ film is 3.9. The sample C1A is employed as a sample to examine the relative dielectric constant.

The relative dielectric constant is calculated based on the result that is obtained by superposing a small signal having a frequency of 1 MHz onto the DC voltage (V) applied between the Si substrate 41 and the electrode 45 in the examined sample S1A, and then measuring the change in a capacitance (C) in response to the change in the DC voltage (V).

### (ii) Concentration of Carbon and Nitrogen in the film

A concentration of carbon and nitrogen in the PE-CVD TMS SiO₂ film 42a is measured by the auger electron spectroscopy method (AES method) using the sample S1.

According to the measuring results, the concentration of carbon is 1.0 atoms%, and the concentration of carbon is 2.1 atoms%.

### (iii) Film density

The film density of the PE-CVD TMS SiO₂ film 42a is examined employing the sample S1 by the well-known X-ray interference method or weight measuring method.

By way of comparison, similar examinations are carried out to the thermal SiO₂ film, the comparative sample CS1 of the PE-CVD TEOS SiO₂ film 51a, and the comparative sample CS2 of the PE-CVD SiH₄ SiO₂ film 52a in place of the PE-CVD TMS SiO₂ film 42a.

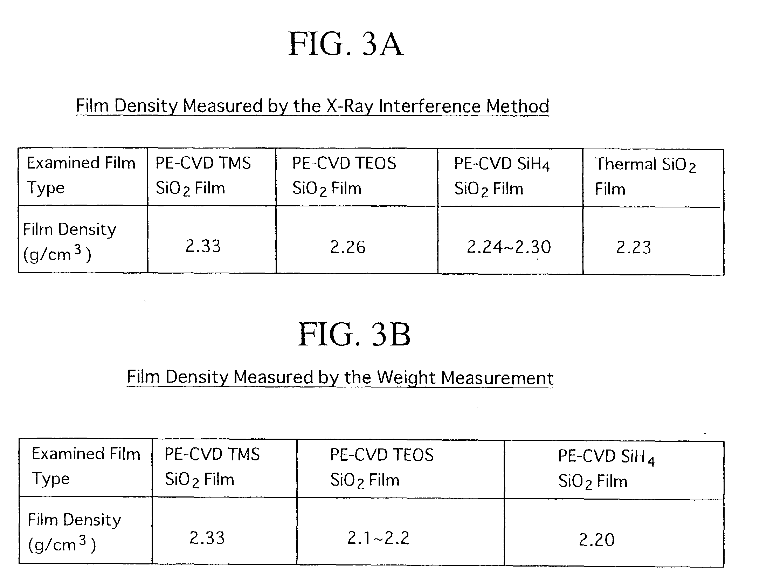

As shown in FIGS.3A and 3B, it is found that the PE-CVD TMS SiO₂ film 42a has the high film density of 2.33 rather than other insulating films and is dense.

### (iv) Amount of contained moisture in the film

An amount of contained moisture in both the film that is obtained immediately after the formation (as deposited) and the film that is left for two weeks in the air is measured employing the sample S1 by the TDS (Thermal Desorption Mass Spectroscopy) method. This TDS method is the way of heating the sample and then measuring the molecules emitted from the sample. For the sake of comparison, the similar examination is carried out to the comparative sample CS1 employing the PE-CVD TEOS SiO₂ film 51a.

The examination is carried out by heating the sample from the room temperature to 800 °C by the TDS analysis equipment and then quantitating the amount of moisture extracted from the sample.

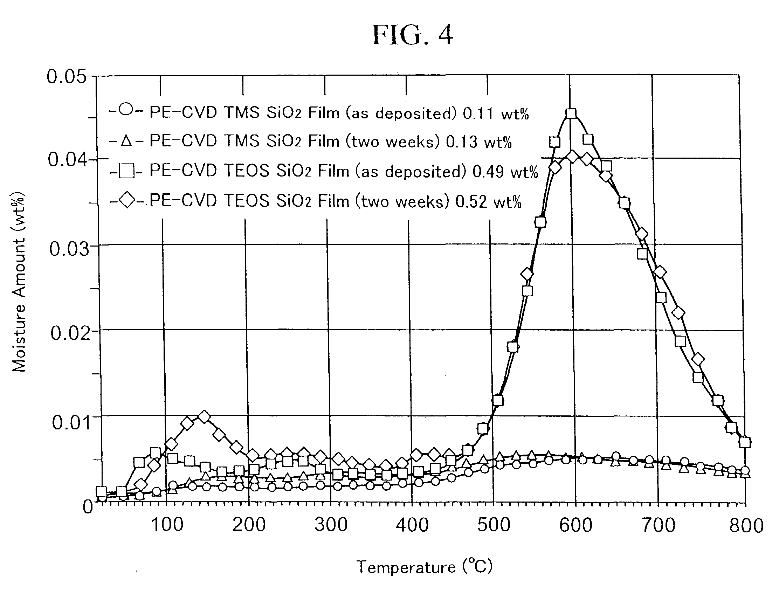

FIG.4 is a graph showing the examined results. In FIG.4, an ordinate denotes the amount of moisture (wt%) represented in a linear scale and an abscissa denotes the temperature (°C) represented in a linear scale.

According to the measurement executed immediately after the film formation (as deposited), when the temperature is risen from the room temperature to 800 °C, the amount of moisture in the PE-CVD TMS SiO₂ film 42a is 0.11 wt% whereas the amount of moisture in the PE-CVD TEOS SiO₂ film 51a is 0.49 wt%. In addition, according to the measurement executed two weeks later, the amount of moisture in the PE-CVD TMS SiO₂ film 42a is increased merely by +0.2 to 0.3 wt% and thus the amount of moisture is seldom varied.

As described above, it is found that both the structural water (the moisture contained in the film due to the film forming gas and the film structure immediately after the film formation) and the physical adsorption water (the incoming moisture that is adsorbed and absorbed physically) in the PE-CVD TMS SiO₂ film 42a are small in contrast to the PE-CVD TEOS SiO₂ film 51a.

### (v) FT-IR Absorption Intensity

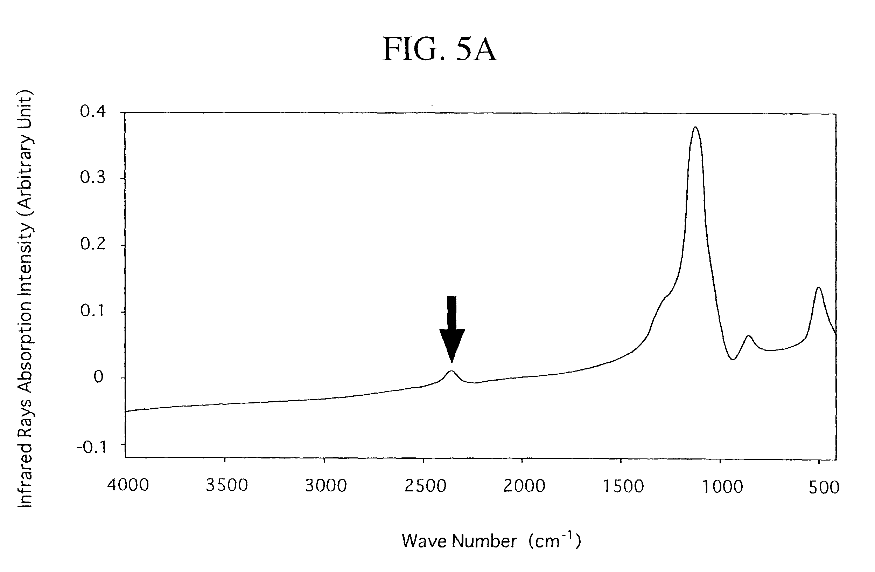

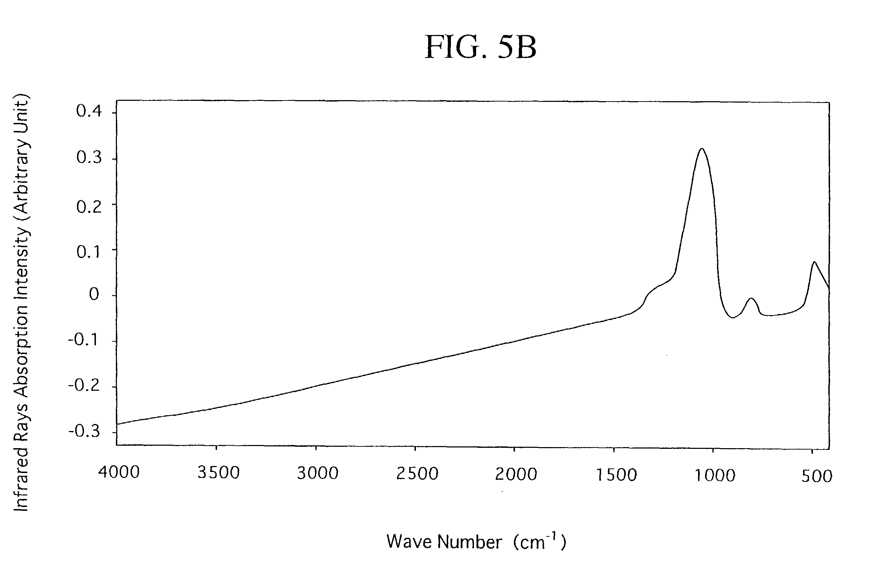

Then, examined results of the infrared rays absorption intensity in the sample S1 by the FT-IR analysis method (Fourier Transform Infrared analysis method) are shown in FIG.5A. Similarly, examined results in the comparative samples CS1, CS2 are shown in FIG.5B.

An ordinate of FIG.5A denotes the absorption intensity expressed in a linear scale (arbitrary unit), and an abscissa denotes the wave number expressed in a linear scale (cm⁻¹). Similarly, this is true of FIG.5B.

As shown in FIG.5A, the peak of the infrared rays absorption intensity having a center wave number in a range of 2270 to 2350 cm⁻¹ is confirmed. In contrast, as shown in FIG.5B, such peak is not watched in the comparative samples CS1, CS2.

### (vi) Water Resistance

The water resistance of the PE-CVD TMS SiO₂ film 42b is exampled by the high pressure humidifying test (pressure-cooker test) while using the samples S2, S3 shown in FIG.2B. By way of comparison, the similar examination is applied to the comparative sample CS3 employing the PE-CVD TEOS SiO₂ film 51b in place of the PE-CVD TMS SiO₂ film 42b and the comparative sample CS5 employing the PE-CVD SiN film 53 similarly.

The conditions of the high pressure humidifying test are given as follows. The leaving time is used as a parameter.
Temperature: 121 °C
Pressure: 2.0 atm
Humidity: 100 % R.T. (Room Temperature)

Evaluation of the water resistance is carried out by evaluating an amount of P=O bonds contained in the examined insulating film after the high pressure humidifying test. In order to evaluate the amount of P=O bonds contained in the BPSG film 43, the P=O absorption coefficient is measured by the FT-IR analysis method. If the moisture enters into the BPSG film 43, the P=O bonds in the film react with the moisture to destroy. In this case, if the PE-CVD TMS SiO₂ film 42b for covering the BPSG film 43 has the high water resistance, such film does not pass through the moisture and thus the P=O bonds in the BPSG film 43 are never destroyed. As a result, it is possible to say that, if the time dependent change of the P=O absorption coefficient becomes smaller, the water resistance becomes higher.

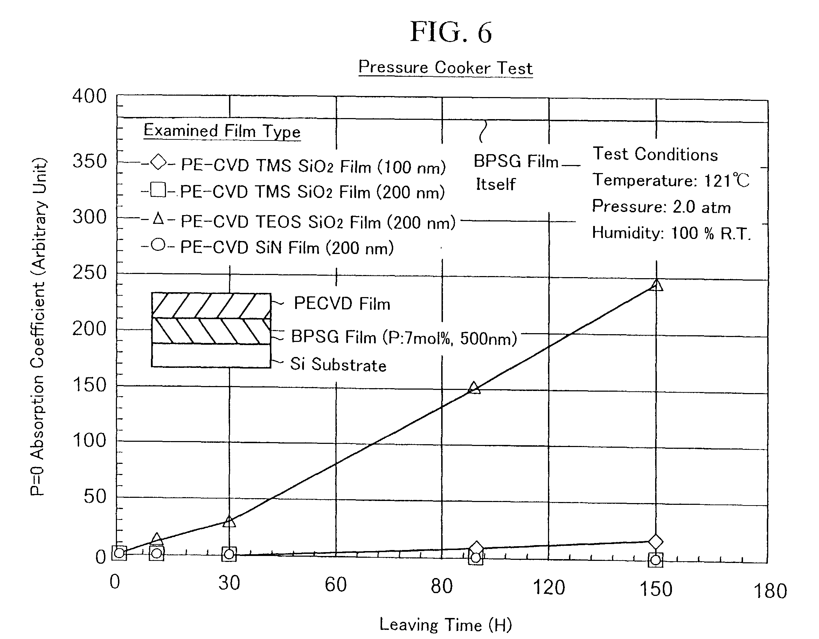

FIG.6 is a graph showing the time dependent change of an amount of contained phosphorus in the insulating film after the high pressure humidifying test is carried out. An ordinate denotes the P=O absorption coefficient (arbitrary unit) expressed in a linear scale, and an abscissa denotes the leaving time (H (hour)) expressed in a linear scale.

Based on the results shown in FIG.6, it is found that, even after both the samples S2, S3 are left for 150 hours as they are, their P=O absorption coefficients are seldom changed from the initial P=O absorption coefficient regardless of the magnitude of the thickness of the PE-CVD TMS SiO₂ film 42b, like the PE-CVD SiN film 53 in the comparative sample CS5, i.e., the PE-CVD TMS SiO₂ film 42b has the water resistance equivalent to the PE-CVD SiN film 53.

Also, the water resistance is examined by another high pressure humidifying test while using the examined sample S3 and the comparative samples CS3, CS4.

The conditions of the high pressure humidifying test are the same as above.

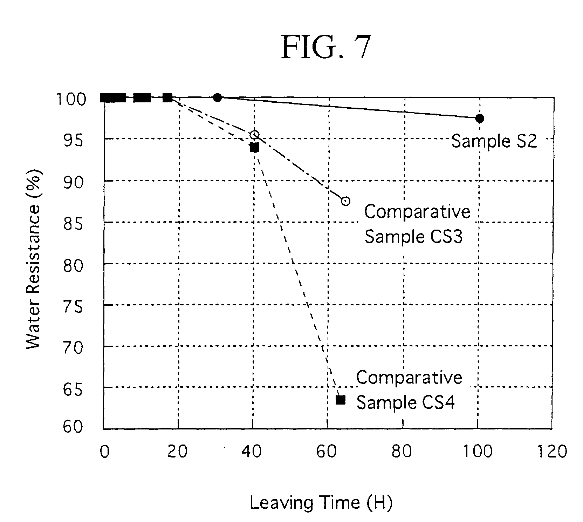

The results are shown in FIG.7. An ordinate of FIG.7 denotes the water resistance (%) expressed in a linear scale, and an abscissa denotes the leaving time (H (hour)) expressed in a linear scale. The sample S3 and the comparative samples CS3, CS4 are used as a parameter.

Like the above, the evaluation of the water resistance is carried out by evaluating an amount of P=O bonds contained in the examined insulating film after the high pressure humidifying test. The water resistance in FIG.7 is derived by calculating the P=O absorption coefficient obtained after the high pressure humidifying test on the basis of the P=O absorption coefficient before the leaving-off, that is assumed as 100.

As shown in FIG.7, it is found that the sample S3 has the water resistance of 97.4 % (100 H), that exceeds the comparative samples CS3, CS4.

### (vii) Leakage current of the film

The examined sample S1A shown in FIG.2E is formed. That is, the electrode 45 is formed on the PE-CVD TMS SiO₂ film 42 having a film thickness (t) of 200 nm in the sample S1 according to the present invention.

The leakage current flowing through the silicon substrate 41 and the electrode 45 is measured by applying the voltage between the silicon substrate 41 and the electrode 45. The silicon substrate 41 is grounded, and the negative voltage is applied to the electrode 45.

According to the results, the leakage current of the PE-CVD TMS SiO₂ film 42a as the single substance is on the order of 10⁻⁸ A/cm² at the electric field strength of 5 MV/cm, and the breakdown voltage is about 10 MV/cm in terms of the electric field.

### (viii) Adhesiveness of the film

The adhesiveness between the PE-CVD TMS SiO₂ film 42c according to the present invention and the underlying low dielectric constant insulating film 44a, 44b is examined employing the samples S4, S5. Also, the sample which is subjected to the surface treatment prior to the film formation and the sample which is not subjected to the surface treatment are prepared, and then the similar examination is carried out. The surface treatment executed prior to the film formation is the treatment for reforming the surface of the processed film by employing the plasma of N₂, NH₃, H₂, etc.

By way of comparison, the PE-CVD TEOS SiO₂ film 51c is employed in place of the PE-CVD TMS SiO₂ film 42c, and similar examinations are carried out employing the inorganic coating insulating film 44a (the comparative sample CS6) and the organic coating insulating film 44b (the comparative sample CS7)as the low dielectric constant insulating film.

As the test for examining the adhesiveness of the film, the peel test by using the tape and the peel test by the CMP (Chemical Mechanical Polishing) on the entire surface of the wafer are carried out.

According to the examined results, regardless of the presence of the surface treatment prior to the film formation, the PE-CVD TMS SiO₂ film 42c has the good adhesiveness to the inorganic coating insulating film 44a and the organic coating insulating film 44b. In contrast, a degree of the adhesiveness of the PE-CVD TEOS SiO₂ film 51c is inferior to the PE-CVD TMS SiO₂ film 42c as a whole. Then, difference in the adhesiveness appeared in response to whether or not the surface treatment is applied prior to the film formation. That is, the sample which is subjected to the surface treatment prior to the film formation had the higher adhesiveness than the sample which is not subjected to the surface treatment.

### (ix) Defect Generating Rate due to Heat Cycle

The defect generating rate due to the heat cycle about the sample S6 and the comparative samples CS8, CS9 is examined. Respective samples are sealed in the package. Test conditions of the heat cycle are given as follows. The cycle number is used as a parameter.
High temperature (holding time): 150 °C (20 minutes)
Low temperature (holding time): -55 °C (20 minutes)
Cycle number: 100, 200, 300, 500 C

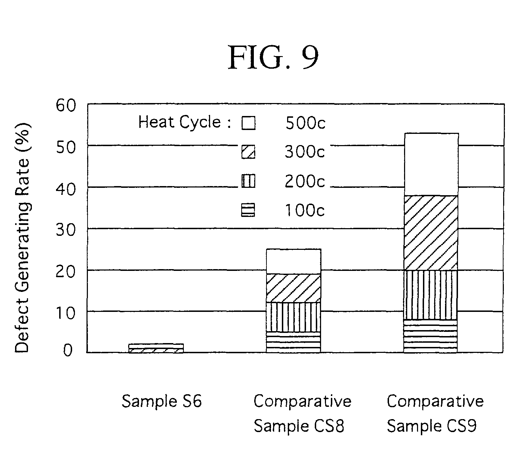

The results are shown in FIG.9. An ordinate of FIG.9 denotes the defect generating rate (%) expressed in a linear scale, and an abscissa denotes the types of the sample. The types of the sample are the sample S6, and the comparative samples CS8, CS9, as explained above, in order from the left side. The partition area indicated by a bar graph denotes a fraction defective at a particular cycle number, the partition area hatched by lateral lines denotes the fraction defective at 100 °C, the partition area hatched by vertical lines denotes the fraction defective at 200 °C, the partition area hatched by oblique lines denotes the fraction defective at 300 °C, and the white partition area on a black ground denotes the fraction defective at 500 °C.

As shown in FIG.9, in the sample S6 employing the silicon oxide film of the present invention as both the upper protection layer and the lower protection layer, the defect is generated at 300 °C or more, but the defect generating rate is about 2 to 3 % even if the defect generating rates at 300 °C and 500 °C are added. In the comparative sample CS8 employing the silicon oxide film 52d of the present invention only as the lower protection layer out of the upper protection layer and the lower protection layer, the defect is generated almost uniformly from 100 °C to 500 °C , and the defect generating rate is about 25 % in total. In the comparative sample CS9 not employing the silicon oxide film 42d, 42e of the present invention as both the upper protection layer and the lower protection layer, the defect is generated from 100 °C to 500 °C. In particular, the defect generating rate at 300 °C and 500 °C are increased, and the defect generating rate is about 53 % in total.
(x) Examination of the barrier characteristic to the copper (Cu)

### (a) TDDB (Time Dependent Dielectric Breakdown) test

The TDDB test measures a time required to come up to the dielectric breakdown when the voltage is applied to the sample.

The examined sample is prepared by stacking the PE-CVD TMS SiO₂ film according to the present invention and the Cu film on the Si substrate in sequence. By way of comparison, the similar examination is applied to the sample employing the PE-CVD TEOS SiO₂ film in place of the PE-CVD TMS SiO₂ film, and the sample interposing the TiN film between the Cu film and the PE-CVD TEOS SiO₂ film.

According to the examined results, the breakdown lifetime of 10 × 10⁵ seconds is obtained at the electric field strength of 8 MV/cm.

In contrast, in the sample employing the PE-CVD TEOS SiO₂ film, the electric field strength is 8 MV/cm to get the breakdown lifetime on the order of 10 × 10⁵ seconds. This means that the breakdown lifetime of the sample employing the PE-CVD TMS SiO₂ film is longer by almost six figures than the sample employing the PE-CVD TEOS SiO₂ film.

In the sample interposing the TiN film between the Cu film and the PE-CVD TEOS SiO₂ film, the electric field strength is 7.5 MV/cm to get the breakdown lifetime on the order of 10×10⁵ seconds.

With the above, it is possible to say that the sample employing the PE-CVD TMS SiO₂ film has the longer breakdown lifetime by almost six figures than the sample employing the PE-CVD TEOS SiO₂ film and has the barrier characteristic to Cu, that is equivalent to or more than the TiN film.

### (b) Examination of heat resistance

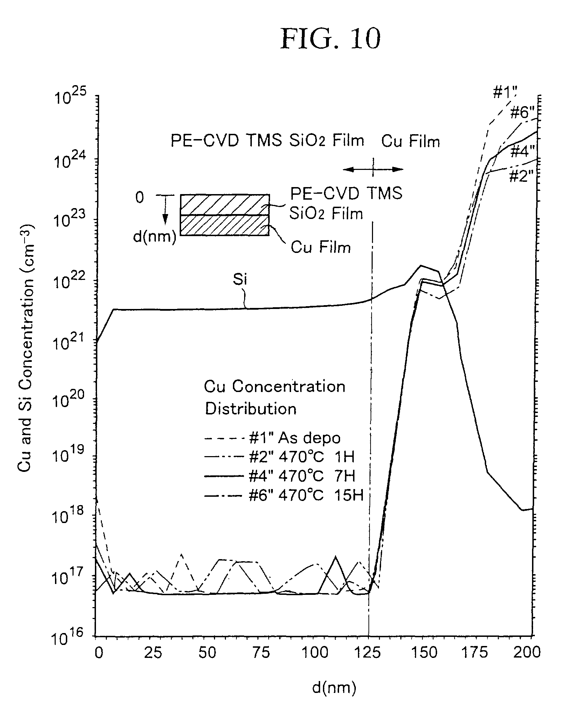

As shown in FIG. 10, the examined sample is prepared by stacking the PE-CVD TMS SiO₂ film of 125 nm thickness according to the present invention and the Cu film on the Si substrate (not shown) to contact to each other.

The examination is made by measuring the Cu concentration distribution state in the PE-CVD TMS SiO₂ film on the basis of the state obtained immediately after the film formation (indicated by a dotted line in FIG.10) after the sample is processed for a predetermined time (three types, i.e., 1 hour (chain double-dashed line), 7 hours (solid line), and 15 hours (dot-dash line)) at the temperature of 470 °C.

FIG.10 is a graph showing the examined results. In FIG.10, an ordinate on the left side denotes a Cu concentration and a Si concentration (cm⁻³) represented in a logarithmic scale. An abscissa denotes a depth (nm) measured from one surface of the PE-CVD TMS SiO₂ film toward the Cu film side and represented in a linear scale.

As shown in FIG.10, the distribution is seldom changed from the distribution obtained immediately after the film formation. In other words, it is found that the PE-CVD TMS SiO₂ film has the sufficient barrier characteristic to the Cu.

In the above, the alkoxy compound (ex. TMS) having Si-H bonds is employed as the silicon-containing gas in the film forming gas. But the siloxane having Si-H bonds may be employed.

Also, N₂O is employed as the oxygen-containing gas in the above. But any one selected from the group consisting of oxygen (O₂), nitrogen dioxide (NO₂), carbon monoxide (CO), carbon dioxide (CO₂) and water (H₂O) may be employed.

In addition, if any one selected from the group consisting of hydrogen (H₂) and nitrogen (N₂) is added to the above film forming gas, the density can be further enhanced.

### (Third Embodiment)

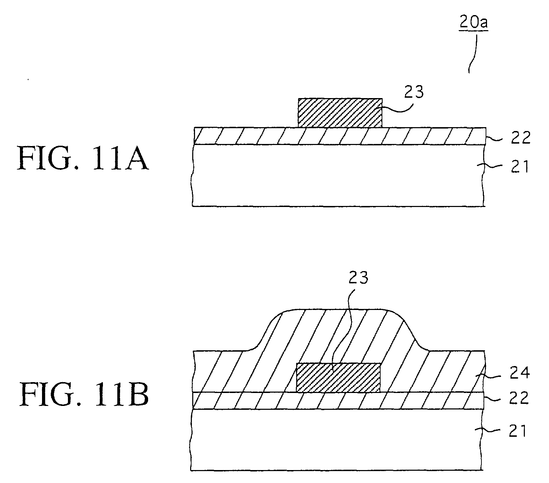

Next, a semiconductor device and a method of manufacturing the same according to a third embodiment of the present invention will be explained with reference to FIGS.11A and 11B hereunder.

FIG.11B is a sectional view showing a semiconductor device according to a third embodiment of the present invention.

As shown in FIG.11B, the silicon oxide film (the silicon-containing insulating film) 24 according to the present invention is formed on the substrate 20a. In the substrate 20a, the underlying insulating film 22 and the wiring 23 are formed on the base substrate 21. The silicon oxide film 24 covers the wirings 23. In the silicon oxide film 24 according to the present invention, a peak of an absorption intensity of an infrared rays is in a range of a wave number 2270 to 2350 cm⁻¹, a film density is in a range of 2.25 to 2.40 g/cm³, and a relative dielectric constant is in a range of 3.3 to 4.3.

In this case, the silicon substrate or the base substrate obtained by forming the wirings and the insulating film on the silicon substrate may be employed as the base substrate 21. The conductive material such as aluminum, copper, etc. may be employed as the material of the wirings 23.

In this manner, the silicon oxide film 24 according to the present invention may be employed as the insulating film that covers the wirings 23 made of the conductive material such as aluminum, copper, etc.

According to the semiconductor device of the third embodiment, the silicon-containing insulating film 24 according to the present invention is formed to come into contact with the wirings 23 and to cover the wirings 23.

The above silicon-containing insulating film 24 has qualities such that the insulating film is dense, is excellent in the water resistance, and has the small amount of contained moisture in the film, which are equivalent to the silicon nitride film, and also has the smaller relative dielectric constant than the silicon nitride film. As a result, if the silicon-containing insulating film according to the present invention is employed as the protection layer 24 for covering the wirings 23, etc., the corrosion of the wirings 23 can be prevented by preventing the permeation of the incoming moisture, while reducing the parasitic capacitance between the wirings 23.

FIGS.11A and 11B are sectional views showing the method for manufacturing the semiconductor device according to the third embodiment of the present invention. TMS+N₂O is employed as the film forming gas for the PE-CVD TMS SiO₂ film according to the present invention.

First, as shown in FIG. 11A, an underlying insulating film 22 made of the PE-CVD TMS SiO₂ film is formed on the silicon substrate 21 by the plasma CVD method using TMS+N₂O as the film forming gas.

In order to form the PE-CVD TMS SiO₂ film, first the silicon substrate 21 is loaded into the chamber 1 of the plasma film forming equipment 101 and held by the substrate holder 3. Then, the silicon substrate 21 is heated to hold at the temperature of 350 °C. TMS and the N₂O gas are introduced into the chamber 1 of the plasma film forming equipment 101 shown in FIG.1 at flow rates of 100 sccm and 3000 sccm respectively to hold the pressure at 0.7 Torr. Then, the power 0.3 W/cm² having the frequency of 380 kHz is applied to the lower electrode 3 and also the power 0.3 W/cm² having the frequency of 13.56 MHz is applied to the upper electrode 2.

Accordingly, TMS and N₂O are plasmanized. The PE-CVD TMS SiO₂ film 22 of about 200 nm thickness is formed while holding this condition for a predetermined time. According to the examination, the formed PE-CVD TMS SiO₂ film 22 had the relative dielectric constant of about 3.9 that is measured at the frequency of 1 MHz, and the leakage current of 10⁻⁸ A/cm² at the electric field strength of 5 MV/cm.

Then, the wiring (lower wiring) 23 is formed on the underlying insulating film 22. Then, as shown in FIG.11B, the PE-CVD TMS SiO₂ film 24 of about 500 nm thickness is formed by the plasma CVD method that is used to form the above PE-CVD TMS SiO₂ film 22.

As described above, according to the third embodiment of the present invention, the underlying insulating film 22 is formed on the silicon substrate 21 before the wiring 23 is formed. The PE-CVD TMS SiO₂ film is dense, has the good water resistance, and has the small amount of contained moisture in the film. Therefore, the underlying insulating film 22 can prevent the moisture in the underlying insulating film 22 and the incoming moisture from reaching the silicon substrate 21.

Also, since the leakage current between the wiring 23 and the silicon substrate 21 can be suppressed, the transistors, the capacitances of the memory elements, etc. are covered with the PE-CVD TMS SiO₂ film in case they are formed on the silicon substrate 21. Therefore, the flowing- out of the accumulated charge can be prevented and thus the reliability of the device can be improved.

In addition, since the PE-CVD TMS SiO₂ film 24 is formed after the wiring 23 is covered, the corrosion of the wiring 23 due to the moisture in the film 24 and the incoming moisture can be prevented.

Further, since the PE-CVD TMS SiO₂ film 24 has the lower relative dielectric constant than the silicon nitride film and the small leakage current, the leakage current between the wirings can be suppressed and the parasitic capacitance between the wirings can be reduced in the situation that a plurality of wirings are provided adjacently or the multi-layered wiring is formed.

### (Fourth Embodiment)

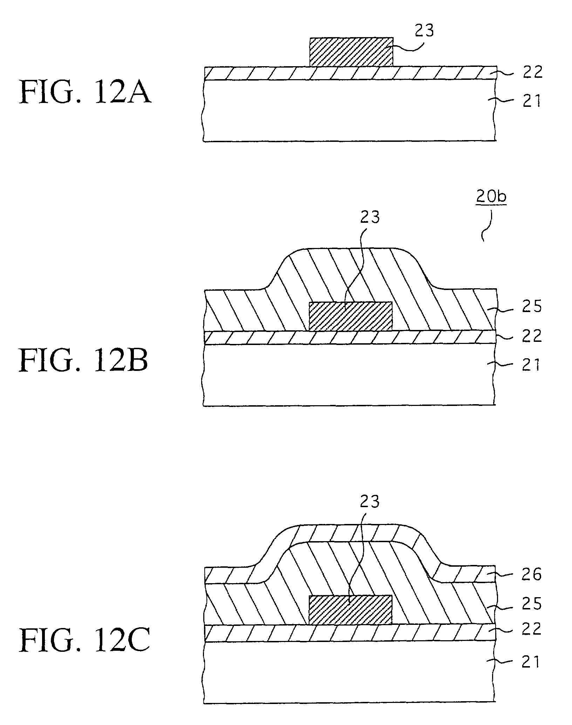

Next, a semiconductor device and a method of manufacturing the same according to a fourth embodiment of the present invention will be explained with reference to FIGS.12A to 12C hereunder.

FIG.12C is a sectional view showing a semiconductor device according to a fourth embodiment of the present invention.

As shown in FIG.12C, the low dielectric constant insulating film 25 such as the porous insulating film, the SiOF film, or the like is formed to cover the wirings 23, and then the protection layer 26 made of the silicon oxide film (silicon-containing insulating film) of the present invention is formed on the insulating film 25.

In the silicon oxide film 26 of the present invention, the peak of the absorption intensity of the infrared rays is in the range of a wave number 2270 to 2350 cm⁻¹, the film density is in the range of 2.25 to 2.40 g/cm³, and the relative dielectric constant is in the range of 3.3 to 4.3.

The above silicon oxide film 26 has the qualities which are equivalent to the silicon nitride film. The silicon oxide film 26 has the small relative dielectric constant, is dense, is excellent in the water resistance, and has the small amount of contained moisture in the film. Accordingly, if the silicon-containing insulating film according to the present invention is employed as the protection layer 26 that covers the wirings 23, etc., the corrosion of the wirings 23 can be prevented by preventing the permeation of the incoming moisture, while reducing the parasitic capacitance between the wirings 23.

In particular, if the porous insulating film having the high hygroscopicity is employed as the insulating film 25 that covers the wirings 23, the incoming of the moisture into the porous insulating film can be prevented and also the increase in the dielectric constant due to the moisture absorption can be prevented.

FIGS.12A to 12C are sectional views showing the method of manufacturing the same according to the fourth embodiment of the present invention. TMS+N₂O is used as the film forming gas.

First, as shown in FIG.12A, like the third embodiment, the underlying insulating film 22 made of the PE-CVD TMS SiO₂ film is formed on the silicon substrate (base substrate) 21 by the plasma CVD method using TMS+N₂O as the film forming gas. The formed PE-CVD TMS SiO₂ film 22 had the relative dielectric constant of about 3.9 that is measured at the frequency of 1 MHz, and the leakage current of 10⁻⁸ A/cm² at the electric field strength of 5 MV/cm.

Then, the wiring (lower wiring) 23 is formed on the underlying insulating film 22. Then, as shown in FIG.12B, a porous insulating film 25 having the low dielectric constant and the film thickness of about 500 nm is formed by the well-known method. These elements constitute a substrate 20b.

Then, as shown in FIG.12C, a protection film 26 made of the PE-CVD TMS SiO₂ film and having the film thickness of about 200 nm is formed by the plasma CVD method that is used to form the above PE-CVD TMS SiO₂ film 22.

As described above, according to the fourth embodiment, the protection film 26 made of the PE-CVD TMS SiO₂ film is formed on the porous insulating film 25 that covers the wiring 23. The PE-CVD TMS SiO₂ film is dense, has the good water resistance, and has the small amount of contained moisture in the film.

Therefore, the protection film 26 can prevent the incoming moisture from reaching the wiring 23. Also, the leakage current of the overall interlayer insulating film including the porous insulating film 25 can be suppressed.

### (Fifth Embodiment)

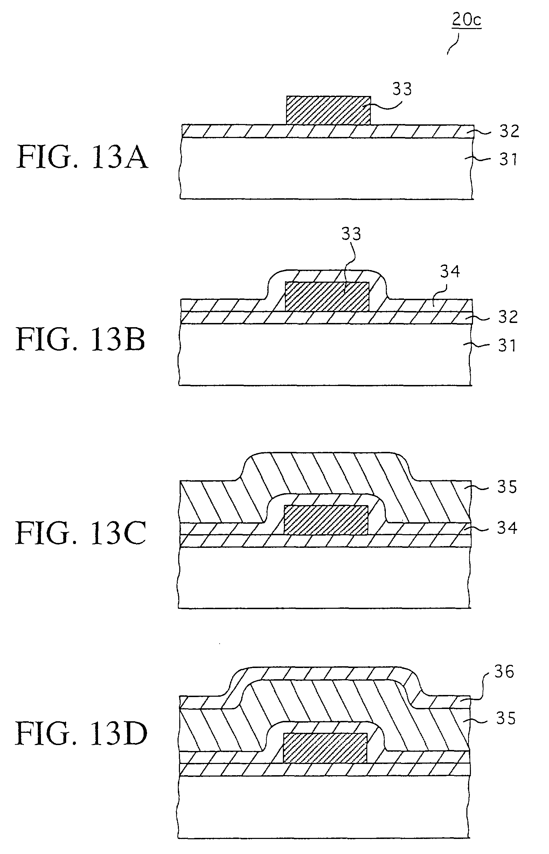

Next, a semiconductor device and a method of manufacturing the same according to a fifth embodiment of the present invention will be explained with reference to FIGS.13A to 13F hereunder.

FIGS.13A to 13F are sectional views showing the semiconductor device and the method of manufacturing the same according to the fifth embodiment of the present invention. In this case, like the third embodiment, TMS+N₂O is used as the film forming gas.

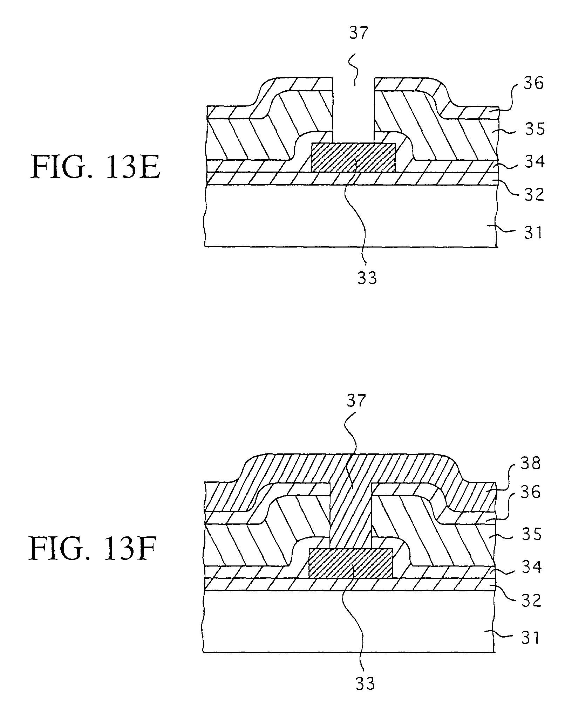

FIG.13F is a sectional view showing a semiconductor device according to a fifth embodiment of the present invention.

As shown in FIG.13F, in the semiconductor device, an underlying insulating film 32 is formed on a base substrate 31, and a lower wiring 33 is formed thereon. Further, an interlayer insulating film is formed to contact to the lower wiring 33 and to cover the lower wiring 33. The same base substrate as the base substrate 21 in FIG.11B may be employed as the base substrate 31.

The interlayer insulating film is formed by laminating a lower protection layer 34 formed of the silicon-containing insulating film according to the present invention, a main insulating film 35, and an upper protection layer 36 formed of the silicon-containing insulating film according to the present invention in sequence from the lower layer. In the silicon-containing insulating film according to the present invention, a peak of the absorption intensity of the infrared rays is in a range of the wave number 2270 to 2350 cm⁻¹, a film density is in a range of 2.25 to 2.40 g/cm³, and a relative dielectric constant is in a range of 3.3 to 4.3.

In this case, the porous insulating film or the SiOF film, that is the insulating film having the low dielectric constant, may be employed as the main insulating film 35.

Also, a via hole 37 is formed in the interlayer insulating film over the lower wiring 33. The lower wiring 33 and the upper wiring 38 are connected via this via hole 37.

As described above, according to the fifth embodiment, since the lower protection layer 34 made of the PE-CVD TMS SiO₂ film is formed to cover the lower wiring 33, the corrosion of the lower wiring 33 due to the moisture contained in the lower protection layer 34 and the incoming moisture can be prevented.

Further, the upper and lower protection layers 34, 36 made of the PE-CVD TMS SiO₂ film are formed to put the main insulating film 35 therebetween.

If the main insulating film 35 is formed of the SiOF film, the diffusion of the fluorine (F) element into the outer peripheral portions of the upper and lower protection layers 34, 36 can be prevented.

Otherwise, if the main insulating film 35 is formed of the porous insulating film, the hygroscopicity is high and the dielectric constant is ready to vary due to the moisture absorption. However, if the main insulating film 35 is sandwiched by the upper and lower protection layers 34, 36, the permeation of the incoming moisture into the main insulating film 35 can be suppressed and thus the dielectric constant of the interlayer insulating film can be stabilized with low value. Also, the leakage current of the overall interlayer insulating film containing the porous insulating film 35 can be suppressed.

Furthermore, the PE-CVD TMS SiO₂ films 34, 36 has the small relative dielectric constant rather than the silicon nitride film, and has the small leakage current. Therefore, in case a plurality of wirings are arranged closely or a multi-layered wiring is formed, the leakage current between the wirings can be suppressed and also the parasitic capacitance between the wirings can be reduced.

In this case, if the underlying insulating film 32 formed on the base substrate 31 is formed of the PE-CVD TMS SiO₂ film according to the present invention, the reaching of the moisture in the underlying insulating film 32 and the incoming moisture to the base substrate 31 can be prevented. Also, if the silicon substrate is employed as the base substrate 31, the leakage current between the lower wiring 33 and the base substrate 31. Therefore, in case the transistors, the capacitors of the memory devices, etc. are formed on the silicon substrate, they are covered with the PE-CVD TMS SiO₂ film. As a result, the flowing-out of the accumulated charges can be prevented and thus the reliability of the device can be improved.

FIGS.13A to 13F are sectional views showing the method of manufacturing the semiconductor device according to the fifth embodiment of the present invention. In this case, like the third embodiment, TMS+N₂O is used as the film forming gas.

FIG.13A is a sectional view showing the state after the wiring is formed. In FIG.13A, a reference 31 denotes a silicon substrate(base substrate); 32, an underlying insulating film; and 33, a wiring (lower wiring). If the wiring 33 is the copper wiring, a TaN film serving as the copper barrier to the underlying insulating film 22 and a Cu film formed by the sputter, although not shown, are formed between the underlying insulating film 32 and the wiring (lower wiring) 33 from the bottom. These films constitute the substrate 20c.

In this state, as shown in FIG.13B, a barrier insulating film (lower protection layer) 34 made of the PE-CVD TMS SiO₂ film having a film thickness of about 50 nm is formed on the wiring 33 by the plasma CVD method using TMS+N₂O.

The barrier insulating film 34 is formed by the same manufacturing method as the underlying insulating film 22 in the third embodiment. The same film forming conditions are employed, their explanation will be omitted herein. According to the examination, the formed barrier insulating film 34 has the relative dielectric constant of about 3.9 that is measured at the frequency of 1 MHz, and the leakage current of 10⁻⁸ A/cm² at the electric field strength of 5 MV/cm.

Then, as shown in FIG. 13C, a porous insulating film 35 having the low dielectric constant and the film thickness of about 500 nm is formed by the well-known plasma CVD method. As the method of forming the porous insulating film, there are the method of forming a multi-layered insulating film by repeating the film formation by the low pressure thermal CVD method and the film formation by the plasma CVD method, the method of laminating the organic film and the SiO₂ film alternatively and then removing the organic film by ashing using the oxygen plasma, etc., for example.

Then, as shown in FIG.13D, a thin and highly dense NSG film (silicon oxide film not-containing the impurity), that serves as a protection film (upper protection layer) 36 for the porous insulating film 35 in the ashing and the etching, is formed. If no protection film 36 is formed, the quality of the porous insulating film 35 is altered by the processing gas when the ashing of the photoresist film is executed or when the barrier insulating film 34 under the porous silicon-containing insulating film 35 is etched, and thus there is the possibility that the low dielectric constant characteristic is degraded. The protection film 36 may be omitted as the case may be.

Then, as shown in FIG.13E, a photoresist film (not shown) is formed and then an opening portion is formed in the via-hole forming area of the photoresist film by patterning the photoresist film. Then, first the protection film 36 is etched and removed via the opening portion in the photoresist film by the reactive ion etching (RIE) using the plasmanized mixed gas containing CF₄+CHF₃. Then, the porous insulating film 35 is etched and removed by using the mixed gas containing CF₄+CHF₃, whose composition ratio is changed from the gas used in the etching of the protection film 36. Accordingly, an opening portion is formed to expose the barrier insulating film 34. Then, the ashing of the photoresist film is executed. At this time, the barrier insulating film 34 has the etching resistance against the etching gas for the porous insulating film 35 and the ashing gas for the photoresist film. As a result, the wiring 33 is not badly affected by the etching gas, etc. A concentration of the mixed gas containing CF₄+CHF₃ may be adjusted by adding Ar+O₂, etc. in addition to etching gas.

Then, the barrier insulating film 34 is etched and removed via the opening portion in the protection film 36 and the opening portion in the porous insulating film 35 by the reactive ion etching (RIE) using the plasmanized mixed gas containing CF₄+CHF₃, that has the same composition ratio as the gas used in the etching of the above protection film 36. Accordingly, a via hole is formed to expose the barrier insulating film 34 from its bottom portion. At this time, the lower wiring 33 has the etching resistance against the etching gas for the above barrier insulating film 34. As a result, the lower wiring 33 is not badly affected by the etching gas. In this case, a surface of the lower wiring 33 is oxidized. But such oxide film may be removed by exposing to the hydrogen plasma diluted with a reducing gas, e.g., an inert gas such as NH₃, argon, nitrogen, or the like after the ashing step of the photoresist film and the etching step of the barrier film are completed.

Then, as shown in FIG.13F, a conductive film is filled in the via hole 37. Then, an upper wiring 38 made of copper or aluminum is formed to be connected to the lower wiring 33 via the conductive film. If the upper wiring 38 is the copper wiring, an underlying conductive film consisting of a barrier metal film, e.g., such as a tantalum nitride (TaN) and a copper film formed by the sputter method is provided in the via hole 37, and then the conductive film is formed thereon.

With the above, the formation of the upper wiring 38 is completed. The upper wiring 38 is connected to the lower wiring 33 via the via holes in the protection film 36, the porous insulating film 35, and the barrier insulating film 34.

As described above, according to the fifth embodiment, the lower wiring 33 is covered with the barrier insulating film 34 made of the PE-CVD TMS SiO₂ film to which the present invention is applied.

By the way, as indicated by the examined results in the second embodiment, the PE-CVD TMS SiO₂ film according to the present invention has the qualities equivalent to the silicon nitride film. The PE-CVD TMS SiO₂ is dense, is excellent in the water resistance, and has the small amount of contained moisture in the film. Accordingly, the corrosion of the lower wiring 33 can be prevented by preventing the permeation of the incoming moisture.

In addition, if the underlying insulating film 32 is formed of the PE-CVD TMS SiO₂ film according to the present invention, all peripheral portions of the lower wiring 33 can be protected by the PE-CVD TMS SiO₂ film. Therefore, the corrosion of the lower wiring 33 can be prevented much more by preventing the permeation of the moisture from all peripheral portions of the lower wiring 33.

Further, upper and lower surfaces of the porous insulating film 35 having the low dielectric constant are protected by the barrier insulating film 34 formed of the PE-CVD TMS SiO₂ film and the protection film 36 formed of the PE-CVD TMS SiO₂ film. Accordingly, the permeation of the incoming moisture into the porous insulating film 35 can be prevented. Therefore, variation in the relative dielectric constant due to the moisture contained in the porous insulating film 35 can be suppressed.

Furthermore, if the moisture is contained in the porous insulating film 35 from the beginning, the flowing-out of such moisture to the peripheral portions can be prevented and thus the corrosion of the lower wiring 33, etc. can be prevented.

Besides, the PE-CVD TMS SiO₂ film has the quality of the density, that is equivalent to the silicon nitride film, but has the quality of the small relative dielectric constant, that is largely different from the silicon nitride film. Accordingly, if the PE-CVD TMS SiO₂ film is employed as the interlayer insulating film, the smaller relative dielectric constant can be maintained. In particular, if the PE-CVD TMS SiO₂ film is employed as the barrier insulating film and the protection film that protect the upper and lower surfaces of the porous insulating film 35, the smaller relative dielectric constant can be maintained as the overall interlayer insulating film containing all of them.

In the above fifth embodiment, a thermal oxide film formed by heating it in the oxygen-containing atmosphere to oxidize the silicon substrate 31, an NSG film formed by the CVD method using the organic silicon-containing gas, a BPSG film (BoroPhosphoSilicate Glass), etc. may be employed as the underlying insulating film 32. But the PE-CVD TMS SiO₂ film which is formed by the plasma CVD method according to the present invention may be employed.

### (Sixth Embodiment)

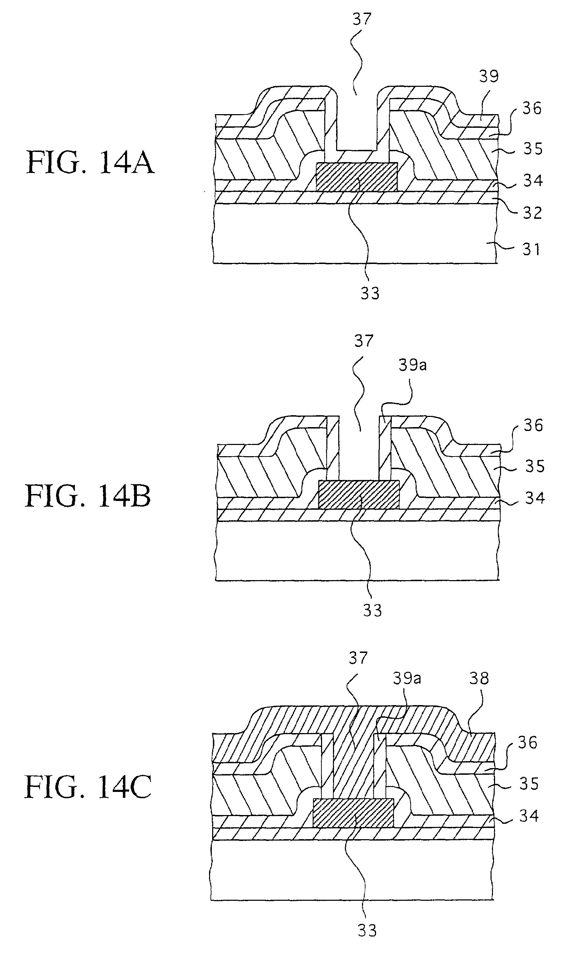

FIGS.14A to 14C are sectional views showing a semiconductor device and a method of manufacturing the same according to a sixth embodiment of the present invention.

FIG.14C is a sectional view showing a semiconductor device according to a sixth embodiment of the present invention.

In this semiconductor device, a difference from the fifth embodiment is that a side wall of the via hole 37 is covered with a PE-CVD TMS SiO₂ film 39a of the present invention and thus the porous insulating film 35 is not exposed from the inner surface of the via hole 37.

In this manner, if a sidewall protection layer 39a made of the PE-CVD TMS SiO₂ film is added to FIG.13F, the porous insulating film 35 can be shielded almost perfectly from the outside by the PE-CVD TMS SiO₂ film according to the present invention. Therefore, the advantage about the entering and discharging of the moisture explained in the fifth embodiment can be enhanced much more.

In order to implement the above structure, as shown in FIG.14A, the PE-CVD TMS SiO₂ film 39 to which the present invention is applied is formed on the protection film 36 so as to cover the via hole 37 after the step shown in FIG.13E. Then, as shown in FIG.14B, the PE-CVD TMS SiO₂ film 39 is etched by the anisotropic etching to leave the PE-CVD TMS SiO₂ film 39a on the sidewall of the via hole 37. Then, as shown in FIG.14C, the upper wiring 38 made of copper or aluminum is formed to be connected to the lower wiring 33 via the conductive film.

With the above, the present invention is explained in detail based on the embodiments, but the scope of the present invention is not limited to examples given concretely in the above embodiments. Variations of the above embodiments may be contained in the scope of the present invention without departing from the gist of the present invention.

### (Other Embodiment)

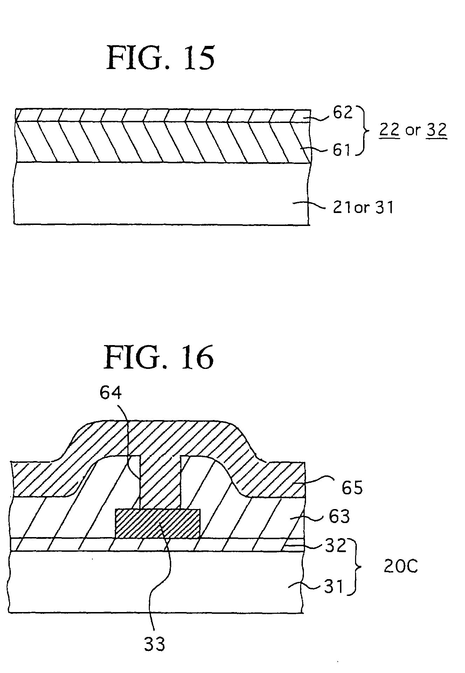

For example, as shown in FIG.15, the underlying insulating film 22 or 32 formed only of the PE-CVD TMS SiO₂ film is formed directly on the silicon substrate 21 or 31, but the underlying insulating film 22 or 32 having the multi-layered structure consisting of double layers, that are formed by laminating the BPSG film or the thermal oxide film 61 and the PE-CVD TMS SiO₂ film 62 in sequence from the bottom, or more may be formed. In this case, it is important to arrange the PE-CVD TMS SiO₂ film at the uppermost layer.

Further, as shown in FIG.16, a single interlayer insulating film 63 interposed between the lower wiring 33 and the upper wiring 65 may be formed on the substrate 20c. In this case, the interlayer insulating film 63 is made of the silicon-containing insulation film. Moreover, the lower wiring 33 and the upper wiring 65 may be connected via an opening portion 64 formed to perforate the interlayer insulating film 63.

As described above, according to the present invention, the silicon-containing insulating film is formed on the substrate. In the silicon-containing insulating film according to the present invention, a peak of the absorption intensity of the infrared rays is in a range of the wave number 2270 to 2350 cm⁻¹, a film density is in a range of 2.25 to 2.40 g/cm³, and a relative dielectric constant is in a range of 3.3 to 4.3.

The silicon-containing insulating film is formed by plasmanizing the film forming gas, that consists of any one selected from the group consisting of the alkoxy compound having Si-H bonds and the siloxane having Si-H bonds and any one oxygen-containing gas selected from the group consisting of oxygen (O₂), nitrogen monoxide (N₂O), nitrogen dioxide (NO₂), carbon monoxide (CO), carbon dioxide (CO₂), and water (H₂O), to react.

According to the experiment, the silicon-containing insulating film in the above range of the peak of the absorption intensity of the infrared rays and in the above range of the film density is dense, has the small relative dielectric constant, and has the small amount of contained moisture in the film. And that film formed in the above manner is same.

Therefore, if the above silicon-containing insulating film is employed as the insulating film to cover wirings or as the barrier insulating film to sandwich the low dielectric constant insulating film that constitutes the interlayer insulating film interposed between the upper wiring and the lower wiring, the dielectric constant of the insulating film to cover wirings or that of the overall interlayer insulating film can be lowered while preventing the corrosion of the wiring and the increase in the leakage current.

## Claims

1. A film forming method comprising the steps of:
preparing a film forming gas, that consists of any one selected from a group consisting of alkoxy compound having Si-H bonds and siloxane having Si-H bonds and any one oxygen-containing gas selected from a group consisting of O₂, N₂O, NO₂, CO, CO₂, and H₂O; and
forming a silicon-containing insulating film (24, 26, 34) on the substrate (20a, 20b, 20c) by plasmanizing the film forming gas to react.

2. A film forming method according to claim 1, wherein at least any one selected from a group consisting of N₂ and H₂ is added to the film forming gas.

3. A film forming method according to claim 1, wherein the alkoxy compound having Si-H bonds is formed of trimethoxysilane (TMS:SiH(OCH₃)₃).

4. A film forming method according to claim 1, wherein the siloxane having Si-H bonds is formed of tetramethyldisiloxane (TMDSO:(CH₃)₂HSi-O-SiH(CH₃)₂).

5. A film forming method according to claim 1, wherein parallel-plate type electrodes (2, 3) are employed as a plasma generating means, and, when a film is formed, a high frequency power having a frequency of 100 kHz to 1 MHz is applied to an electrode (3) on which a substrate (20) is loaded and a high frequency power having a frequency of 1 MHz or more is applied to an electrode (2) opposing to the electrode (3) on which the substrate (20) is loaded.

6. A semiconductor device manufacturing method comprising the steps of:
preparing a substrate (20a, 20c) on a surface of which a wiring (23, 33) is formed; and
forming a silicon-containing insulating film (24, 34) for covering the wiring (23, 33) by plasmanizing a film forming gas, that consists of any one selected from a group consisting of alkoxy compound having Si-H bonds and siloxane having Si-H bonds and any one oxygen-containing gas selected from a group consisting of O₂, N₂O, NO₂, CO, CO₂, and H₂O, to react.

7. A semiconductor device manufacturing method according to claim 6, wherein the silicon-containing insulating film (24, 34) for covering the wiring (23, 33) is a protection layer.

8. A semiconductor device manufacturing method according to claim 7, further comprising the step of forming an insulating film (35), whose film thickness is thicker than the protection layer (34), on the protection layer (34), after the step of forming the protection layer (34) for covering the wiring (33).

9. A semiconductor device in which a silicon-containing insulation film (24, 26, 34) whose peak of an absorption intensity of an infrared rays is in a range of a wave number 2270 to 2350 cm⁻¹, whose film density is in a range of 2.25 to 2.40 g/cm³, and whose relative dielectric constant is in a range of 3.3 to 4.3 is formed on a substrate (20a, 20b, 20c).

10. A semiconductor device according to claim 9, further comprising a wiring (23, 33) is formed on a surface of the substrate (20a, 20c),
wherein the silicon-containing insulation film (24, 34) covering the wiring (23, 33) to come into contact with the wiring (23, 33).

11. A semiconductor device according to claim 9, further comprising :
a wiring (23) ;
an insulating film (25) that covers the wiring to come into contact with the wiring (23) are formed on a surface of the substrate (20b) ; and
an protection layer (26) made of the silicon-containing insulation film formed on the insulating film (25).

12. A semiconductor device according to claim 9, further comprising:
a wiring (33) formed on a surface of the substrate (20c);
a lower protection layer (34) that covers the wiring (33) to come into contact with the wiring (33);
a main insulating film (35) that is laminated on the lower protection layer (34) to come into contact with the lower protection layer (34); and
an upper protection layer (36) that is laminated on the main insulating film (35) to come into contact with the main insulating film (35),
wherein both the lower protection layer (34) and the upper protection layer (36) are made of the silicon-containing insulation film.

13. A semiconductor device according to claim 12, wherein the main insulating film (35) is made of any one selected from the group consisting of an SiOF film and a porous insulating film.

14. A semiconductor device according to claim 9, further comprising:
an lower wiring;
a upper wiring; and
an interlayer insulating film interposed between the lower wiring and the upper wiring are formed on the substrate,
wherein the interlayer insulating film is made of the silicon-containing insulation film.

15. A semiconductor device according to claim 14, wherein the lower wiring and the upper wiring are connected via an opening portion formed to perforate the interlayer insulating film.

16. A semiconductor device according to claim 9, further comprising:
(i)a lower wiring (33) formed on a surface of the substrate (20c);
(ii)an upper wiring (38); and
(iii)an interlayer insulating film interposed between the lower wiring (33) and the upper wiring (38), the interlayer insulating film comprising
(a)a lower protection layer (34) made of the silicon-containing insulation film that covers the lower wiring (33) to come into contact with the lower wiring (33),
(b)a main insulating film (35) that is laminated on the lower protection layer (34) to come into contact with the lower protection layer (34), and
(c)an upper protection layer (36) made of the silicon-containing insulation film that is laminated on the main insulating film (35) to come into contact with the main insulating film (35)
wherein both the lower protection layer (34) and the upper protection layer (36) are made of the silicon-containing insulation film.

17. A semiconductor device according to claim 16, wherein the main insulating film (35) is any one selected from a group consisting of an SiOF film and a porous insulating film.

18. A semiconductor device according to claim 16, further comprising:
an opening portion (37) formed to perforate the interlayer insulating film; and
a side-wall protection layer (39a) made of the silicon-containing insulation film is formed on a side wall of the opening portion (37),
wherein the lower wiring (33) and the upper wiring (38) are connected via the opening portion (37).
